# EUROPEAN PATENT SPECIFICATION

(11) **EP 3 640 996 B1**
(45) Date of publication and mention of the grant of the patent: **28.09.2022**
(21) Application number: 18200459.8
(22) Date of filing: 15.10.2018
(51) Int. Cl.: H01L 29/739, H01L 29/78, H01L 29/06, H01L 29/08, H01L 29/10, H01L 29/423, H01L 29/417, H01L 29/40

(54) **SEMICONDUCTOR DEVICE**
HALBLEITERBAUELEMENT
DISPOSITIF À SEMICONDUCTEUR

(43) Date of publication of application: 22.04.2020
(73) Proprietor: Infineon Technologies Austria AG, 9500 Villach (AT)
(72) Inventor: Kowalik-Seidl, Katarzyna, 82008 Unterhaching (DE); Fischer, Björn, 81547 München (DE); Hensch, Richard, 01277 Dresden (DE); Kaindl, Winfried, 82008 Unterhaching (DE); Schmitt, Markus, 85579 Neubiberg (DE)
(74) Representative: Westphal, Mussgnug & Partner, Patentanwälte mbB

(56) References cited:
- US-A1- 2008 265 315
- US-A1- 2014 197 477
- US-A1- 2014 209 970
- US-A1- 2014 327 114

## Description

### TECHNICAL FIELD

The instant disclosure relates to a semiconductor device with an increased avalanche capability.

### BACKGROUND

Semiconductor devices such as insulated gate power transistor devices, e.g., power MOSFETs (Metal Oxide Semiconductor Field-Effect Transistors) or IGBTs (Insulated Gate Bipolar Transistors), are widely used as electronic switches in various types of electronic applications. In many applications the reliability of such semiconductor devices is a critical aspect. Many applications require the switching of undamped inductive loads which may cause high stresses within the transistor device due to high currents which induce high device temperatures. In some applications, the avalanche capability of the transistor device is limited and the stresses on the transistor device result in local defects, especially in the peripheral regions of the active device cells near the edge termination. Such local defects may eventually lead to the failure of the device. Document US 2008/265315 A1 discloses a semiconductor device with a semiconductor body. The semiconductor body has first electrodes which contact first highly doped semiconductor zones and complementary-conduction body zones surrounding the first semiconductor zones. The semiconductor body has a second electrode which contacts a second highly doped semiconductor zone. Between the second semiconductor zone and the body zones, a drift zone is arranged. Control electrodes which are insulated from the semiconductor body by a gate oxide act on the body zones for controlling the semiconductor device and are arranged on the semiconductor body. The body zones have minority charge carrier injector zones with complementary conduction to the body zones, arranged between the first semiconductor zones and the drift zone. The semiconductor device of US 2008/265315 A1 is further provided with an edge termination. Document US 2014/209970 A1 discloses a semiconductor device including a semiconductor layer with a drift zone of a first conductivity type and at least one impurity zone of a second, opposite conductivity type. The impurity zone adjoins a first surface of the semiconductor portion in an element area. A connection layer directly adjoins the semiconductor layer opposite to the first surface. At a distance to the first surface an overcompensation zone is formed in an edge area that surrounds the element area. The overcompensation zone and the connection layer have opposite conductivity types. In a direction vertical to the first surface, a portion of the drift zone is arranged between the first surface and the overcompensation zone. In case of locally high current densities, the overcompensation zone injects charge carriers into the semiconductor layer that locally counter a further increase of electric field strength and reduce the risk of avalanche breakdown.

Document US 2014/197477 A1 discloses a superjunction semiconductor. A drain drift portion substantially corresponds to a portion just under p-base regions serving as an active region and forms a first parallel pn structure in which a first n-type region and a first p-type region are joined to each other alternately and repeatedly. A drain drift portion is surrounded by edge termination region including a second parallel pn structure. Edge termination region is formed such that second n-type and p-type regions oriented consecutively to the first parallel pn structure of the drain drift portion are joined to each other alternately and repeatedly. N-buffer layer is provided between first and second parallel pn structures and n+ drain layer. P-buffer layer is provided selectively inside n-buffer layer in edge termination region.

Document US 2014/327114 A1 discloses a semiconductor component including a two-sided semiconductor body, an inner zone with a basic doping of a first conduction type, and two semiconductor zones. The first zone, disposed between the first side and inner zone, is of the first conduction type with a doping concentration higher than that of the inner zone. The second zone, disposed between the second side and inner zone, is of a second conduction type complementary to the first type with a doping concentration higher than that of the inner zone. At least one first edge chamfer extends at a first angle to the extension plane of the transition from the second zone to the inner zone at least along the edge of the second zone and inner zone. At least one buried zone of the second conduction type is provided between the first zone and inner zone, and extends substantially parallel to the first zone.

It is desirable to provide a robust semiconductor device that has an increased avalanche capability and an increased lifetime.

### SUMMARY

The vertical semiconductor device according to the invention is defined in claim 1, said vertical device includes a semiconductor body comprising a first surface, a second surface opposite to the first surface in a vertical direction, an edge termination region, and an active region arranged adjacent to the edge termination region in a horizontal direction. The semiconductor device further comprises a plurality of transistor cells at least partly integrated in the active region, each transistor cell comprising a source region, a body region, a drift region separated from the source region by the body region, and a gate electrode dielectrically insulated from the body region, a first semiconductor layer of a first doping type arranged between the drift regions and the second surface in the edge termination region and in the active region, and a buffer region arranged in the first semiconductor layer and comprising a first section extending in the horizontal direction into the edge termination region, and an adjoining second section extending in the horizontal direction into the active region. The second section has a width in the horizontal direction which is at least twice the width and less than twenty times the width of a transistor cell, and the buffer region either has a second doping type complementary to the first doping type, or has the first doping type and a doping concentration lower than a doping concentration of the first semiconductor layer. Each of the plurality of transistor cells further comprises a compensation region of a doping type complementary to the doping type of the drift region and extending from a respective body region into the drift region in the vertical direction, and the width of a first pitch equals a distance between the central planes of two successive compensation regions.

Examples are explained below with reference to the drawings. The drawings serve to illustrate certain principles, so that only aspects necessary for understanding these principles are illustrated. The drawings are not to scale. In the drawings the same reference characters denote like features.

### BRIEF DESCRIPTION OF THE DRAWINGS

Figure 1, including Figures 1A and 1B, schematically illustrates cross sectional views of a semiconductor body according to an example useful for understanding the invention.
Figure 2 schematically illustrates a cross sectional view of another semiconductor according to another example useful for understanding the invention.
Figure 3 schematically illustrates a cross sectional view of a semiconductor device according to one example of the invention.
Figure 4, including Figures 4A - 4C, schematically illustrates cross sectional views of semiconductor devices according to further examples.
Figure 5 schematically illustrates a cross sectional view of a semiconductor device according to another example of the invention.
Figure 6, including Figures 6A - 6C schematically illustrates cross sectional views of semiconductor devices according to further examples of the invention.
Figure 7 schematically illustrates a top view of a semiconductor body.
Figure 8, including Figures 8A - 8C, schematically illustrates top views of semiconductor bodies of semiconductor devices according to different examples of the invention.
Figure 9, including Figures 9A and 9B, illustrates top views of semiconductor bodies of semiconductor devices according to further examples of the invention.
Figure 10, including Figures 10A and 10B, schematically illustrates cross sectional views of semiconductor devices according to further examples of the invention.

### DETAILED DESCRIPTION

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

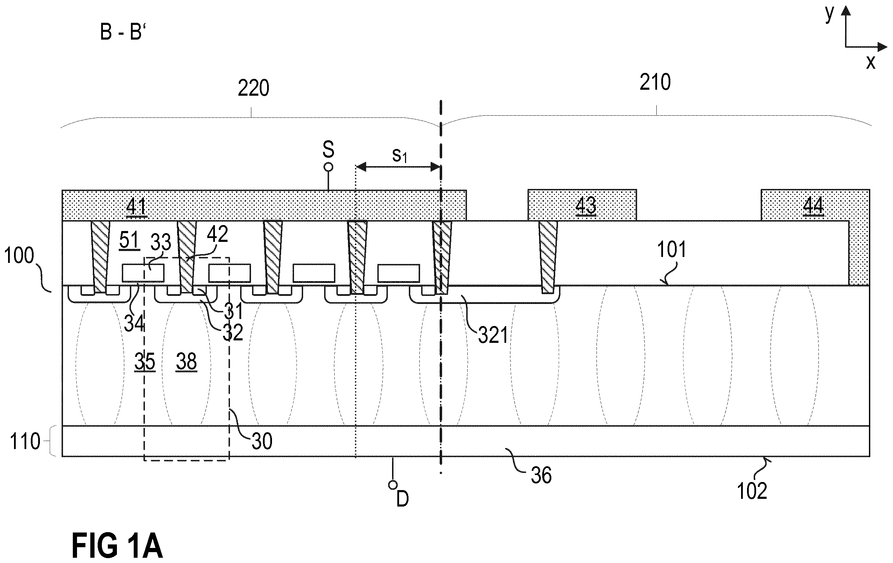

Referring to Figure 1A, a cross-sectional view of a semiconductor device useful for understanding the invention comprising a semiconductor body 100 is schematically illustrated. The semiconductor body 100 may include a conventional semiconductor material such as, for example, silicon (Si), silicon carbide (SiC), gallium nitride (GaN), gallium arsenide (GaAs), or the like. A transistor device is formed in the semiconductor body 100, the transistor device being arranged in an active region 220 of the semiconductor body 100. In Figure 1A, only a small section of the transistor device is shown. In its active region 220, the semiconductor body 100 includes at least one working transistor cell 30 with a gate electrode 33 that is dielectrically insulated from a body region 32 by a gate dielectric 34. The body region 32 is a doped semiconductor region in the active region 220 of the semiconductor body 100. In the example illustrated in Figure 1A, the body region 32 extends from a first surface 101 into the semiconductor body 100, and the gate electrode 33 is arranged above the first surface 101 of the semiconductor body 100.

The transistor device illustrated in Figure 1A further includes a drift region 35 formed in the semiconductor body 100. The drift region 35 adjoins the body region 32 of the at least one transistor cell 30 and forms a pn-junction with the body region 32. The drift region 35 is arranged between the body region 32 of the at least one transistor cell 30 and a drain region 36. The drain region 36 may adjoin the drift region 35 (as illustrated). The drain region 36 may form a semiconductor layer 110 that is arranged between a second surface 102 of the semiconductor body 100 and the drift region 35. The second surface 102 is arranged opposite to the first surface 101 in a vertical direction y of the semiconductor body 100.

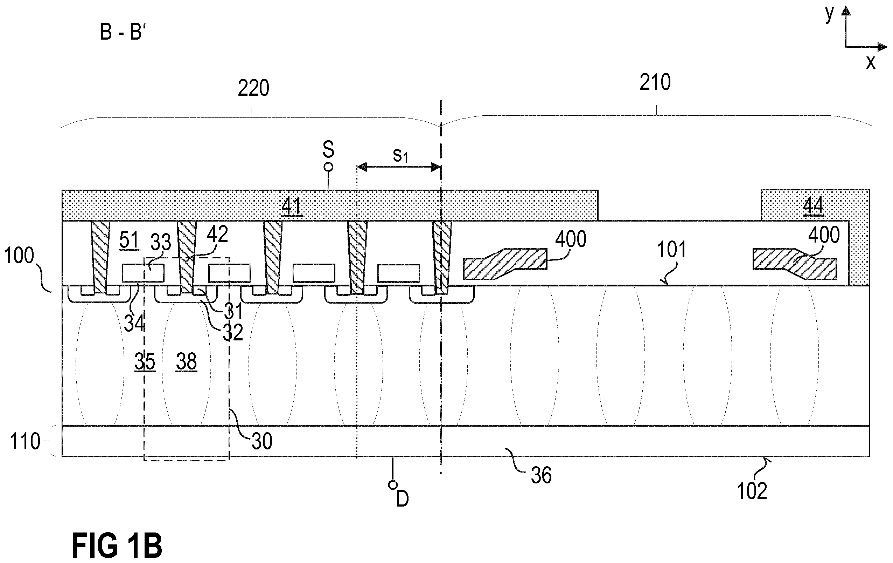

Now referring to Figure 1B, a cross-sectional view of a semiconductor device comprising a semiconductor body 100 according to another example useful for understanding the invention is schematically illustrated. The transistor device illustrated in Figure 1B corresponds to the transistor device as has been described with respect to Figure 1A above. The semiconductor device illustrated in Figure 1B differs from the semiconductor device illustrated in Figure 1A mainly in the implementation of an edge termination region 210, as will be described in further detail below.

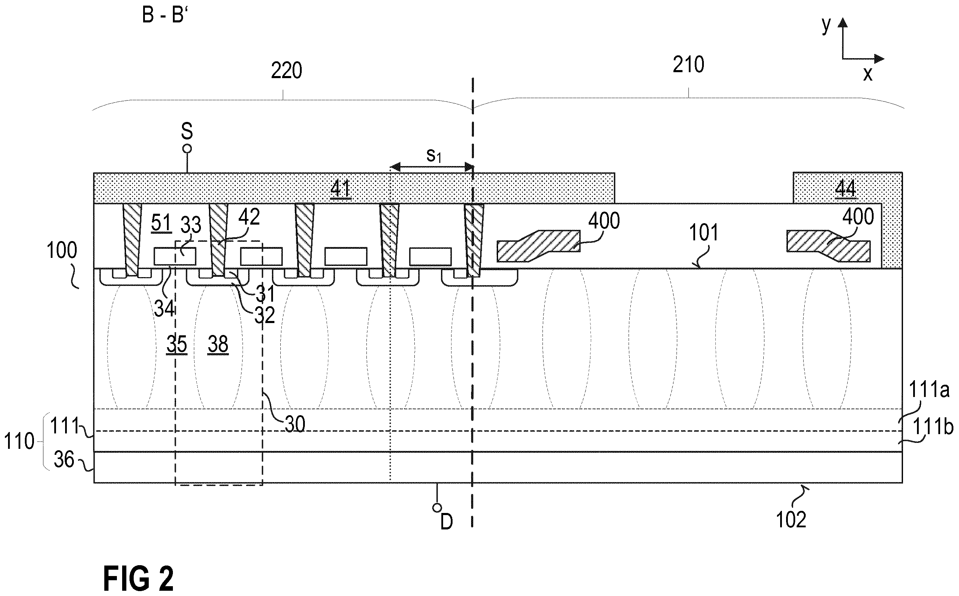

According to another example useful for understanding the invention, as is illustrated in Figure 2, a field-stop-region 111 of the same doping type as the drift region 35 is arranged between the drift region 35 and the drain region 36. In a semiconductor body 100 comprising such a field-stop-region 111, the semiconductor layer 110 between the second surface 102 and the drift 35 region may be formed by the drain region 36 and the adjoining field-stop-region 111, as is illustrated in Figure 2. The field-stop-region 111 may be formed by a single layer or by a plurality of separate sub-layers, e.g., at least two sub-layers. In Figure 2, two sub-layers 111a, 111b, forming the field-stop-region 111 are schematically illustrated. Sub-layers that are arranged closer to the drift region 35 (e.g., first sub-layer 111a in Figure 2) may be less highly doped than sub-layers that are arranged further away from the drift region 35 (e.g., second sub-layer 111b in Figure 2). For example, a doping concentration of a sub-layer that is arranged adjacent to the drift region 35 (e.g., first sub-layer 111a) may be selected from a range of between 1E15 and 1E16 cm⁻³ or lower. A doping concentration of a sub-layer that is arranged adjacent to the drain region 36 (e.g., second sub-layer 111b) may be higher than a doping concentration of a sub-layer that is arranged horizontally above (e.g., doping concentration of second sub-layer 111b is higher than doping concentration of first sub-layer 111a). The doping concentration of the sub-layer that is arranged adjacent to the drain region 36, however, may be lower than a doping concentration of the drain region 36. Generally speaking, a doping concentration of the different sub-layers may increase from the drift region 35 towards the drain region 36.

Referring to both Figures 1 and 2, the transistor device includes at least one compensation region 38 of a doping type complementary to the doping type of the drift region 35. According to one example, the transistor device includes a plurality of transistor cells 30 and each transistor cell 30 includes a compensation region 38 adjoining the body region 32 of the respective transistor cell 30. In a vertical direction y of the semiconductor body 100, which is a direction perpendicular to the first surface 101, the at least one compensation region 38 extends from the body region 32 into the semiconductor body 100 towards the drain region 36.

Still referring to Figures 1 and 2, the transistor device further includes a source electrode 41. The source electrode 41 is electrically connected to the source region 31 and the body region 32 of the at least one transistor cell 30 by means of contact plugs 42. The contact plugs 42 may comprise at least one of tungsten, aluminum, copper, and a Ti/TiN barrier liner, for example. This source electrode 41 forms a source node S or is electrically connected to a source node S of the transistor device. The transistor device further includes a drain node D electrically connected to the drain region 36. A drain electrode electrically connected to the drain region 36 may form the drain node D. However, such drain electrode is not explicitly illustrated in Figures 1 and 2.

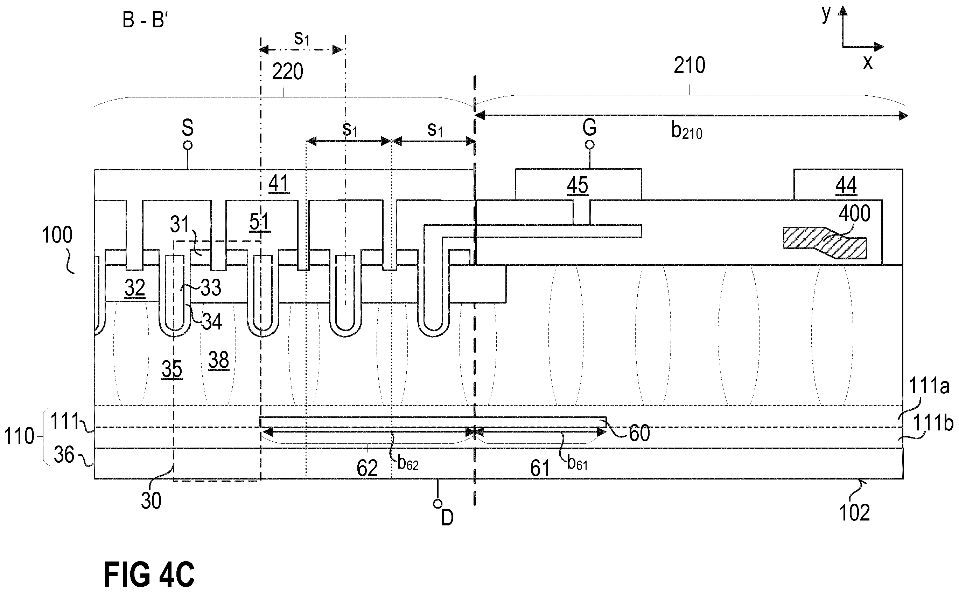

The transistor device can be an n-type transistor device or a p-type transistor device. The device type is defined by the doping type of the source region 31. In an n-type transistor device, the source region 31 is an n-type region, the body region 32 is a p-type region, the drift region 35, which has a doping type complementary to the doping type of the body region 32, is an n-type region, and the at least one compensation region 38 is a p-type region. In a p-type transistor device, the source region 31 is a p-type region, the body region 32 is an n-type region, the drift region 35 is a p-type region, and the at least one compensation region 38 is an n-type region. The transistor device can be implemented as a MOSFET or as an IGBT, for example. In a MOSFET, the drain region 36 has the same doping type as the drift region 35, and in an IGBT the drain region 36 (which may also be referred to as collector region) has a doping type complementary to the doping type of the drift region 35. For example, a doping concentration of the drain region 36 is selected from a range of between 1E18 and 1E19 cm⁻³, 1E18 and 1E20 cm⁻³, or 1E18 and 1E21 cm⁻³, doping concentrations of the drift region 35 and the compensation region 38 are selected from a range of between 1E15 and 5E16 cm⁻³, and a doping concentration of the body region 32 is selected from between 5E16 cm⁻³ and 5E17 cm⁻³. The transistor cells 30 illustrated in the Figures are planar transistor cells. Implementing the transistor cells 30 as planar transistor cells, however, is only one example. According to another example , the transistor cells 30 are implemented as trench transistor cells. That is, the at least one gate electrode 33 is arranged in a trench that extends from the first surface 101 of the semiconductor body 100 into the semiconductor body 100. This will be explained in more detail with respect to Figure 4C below.

In an IGBT, the source region 31 may also be referred to as emitter region, and the drain region 36 may be referred to as collector region. In the following, the respective regions will be referred to as source region 31 and drain region 36, irrespective of whether the transistor device is a MOSFET or an IGBT.

In the transistor device explained above, a plurality of transistor cells 30 is connected in parallel. That is, the source regions 31 of these transistor cells 30 are connected to the source node S, the common drain region 36 is connected to the drain node D, and the at least one gate electrode 33 is connected to a gate node (not illustrated in Figures 1 and 2).

The source electrode 41 in the example of Figures 1 and 2 is not a continuous layer completely covering the semiconductor body 100. Referring to Figure 1A, a field plate electrode 43 may be arranged adjacent to the source electrode 41 in a horizontal direction x of the semiconductor body 100. The source electrode 41 and the field plate electrode 43, however, are not directly connected to each other but are spaced apart with a gap formed between the source electrode 41 and the field plate electrode 43. The source electrode 41 and the field plate electrode 43 are electrically connected to each other via a base region 321 formed in the semiconductor body 100. The base region 321 may be of the same doping type as the body regions 32. The base region 321 may extend from the first surface 101 into the semiconductor body 100 and may have a larger width in the horizontal direction x as compared to the body regions 32. The source electrode 41 and the field plate electrode 43 are electrically connected to the base region 321 by means of contact plugs. The contact plugs, similar to the contact plugs 42 connecting the source electrode 41 and the body regions 32, may comprise at least one of tungsten, aluminum, copper, and a Ti/TiN barrier liner, for example.

Figures 1B and 2, for example, schematically illustrate another possible implementation. According to Figures 1B and 2, the field plate electrode 43 may be replaced by one or more floating field plate electrodes 400. Such floating field plate electrodes 400 may be formed from polycrystalline semiconductor material, for example, and may not be electrically connected to any of the other elements of the semiconductor device. In the examples illustrated in Figures 1B and 2, contact plugs 42, therefore, are only used to connect the source electrode 41 to the body regions 32, while no contact plugs are needed to contact the field plate electrodes 400.

The contact plugs 42 that are arranged below the source electrode 41 and, optionally, below the field plate electrode 43 extend from the source and body regions 31, 32 or from the base region 321 through an insulation layer 51 that is formed on the top surface 101 of the semiconductor body 100 to the source electrode 41 or the field plate electrode 43 to electrically couple the source and body regions 31, 32 to the source electrode 41 and the base region 321 to the field plate electrode 43, respectively. In the Figures, the insulation layer 51 is illustrated as a single continuous layer which extends from the first surface 101 of the semiconductor body 100 to the source electrode 41 and the field plate electrode 43. This, however, is only an example. Often, a gate oxide layer with a thickness of, e.g., 5nm to 200nm or 40nm to 120nm, is arranged on the surface 101 of the semiconductor body 100. The insulation layer 51 may comprise this gate oxide layer and an additional layer which is formed on top of this gate oxide layer. This additional layer may comprise an undoped TEOS (tetraethyl orthosilicate) which may have a thickness of about 50nm to 500nm, and a doped BPSG (borophosphosilicate glass) having a thickness of about 200nm to 2µm or 1100nm to 1300nm, for example. The insulation layer 51, therefore, may comprise several sub-layers which, however, are not explicitly illustrated in the Figures.

Floating field plate electrodes 400 may be arranged within the insulation layer 51 and may be completely surrounded by the material of the insulation layer 51, for example, as is illustrated in Figures 1B and 2. The source electrode 41 and one of the floating field plate electrodes 400 may at least partly overlap each other, for example. That is, the floating field plate electrode 400 may be arranged at least partly below the source electrode 41 in a vertical direction y. In a horizontal direction x, one of the floating field plate electrodes 400 may also overlap with one of the body regions 32, for example.

Implementing the source electrode 41 and a field plate electrode 43 as separate electrodes without a direct electrical connection (see Figure 1A), is only an example. According to another example (not illustrated), the source electrode 41 and the field plate electrode 43 may be implemented adjacent to each other without a gap formed therebetween such that a direct electrical connection is provided between the source electrode 41 and the field plate electrode 43. Any other implementations of field plate electrodes 43, 400 are also possible.

A semiconductor body 100 usually comprises not only an active region 220, but also an inactive region, also referred to as passive region or edge termination region 210. The semiconductor arrangement, that is, the plurality of transistor cells 30, may be implemented within the active region 220 of the semiconductor body 100. An edge termination region 210, e.g., may be a region adjacent to the horizontal edges of the semiconductor body 100 (edge region). According to one example, the active region 220 is horizontally surrounded by the edge termination region 210. The edge termination region 210 generally does not comprise any working transistor cells 30. In particular, an edge termination region 210 may be a region that does not include all active components that are necessary to form a functioning (working) transistor cell 30. Active components are, e.g., gate oxide, source regions 31, body regions 32, gate electrodes 33, or drain regions 36. For example, the edge termination region 210 may be a region within the semiconductor body 100 which does not comprise any source regions 31.

The source electrode 41 may be arranged on the active region 220 of the semiconductor body 100. An optional field plate electrode 43, for example, may be arranged on the edge termination region 210 of the semiconductor body 100. Floating field plate electrodes 400 may also be arranged on the edge termination region 210. Generally speaking, conductive field plates 43, 400 may be used on the edge termination region 210 of the semiconductor body 100 in order to spread the electric field more uniformly in the edge termination region 210. Such field plates 43, 400 may be electrically connected to the underlying pillars formed by the drift regions 35 and the compensation regions 38, such that they can assume the potential of the corresponding pillars. As has been described above, it is, however, also possible to use floating field plates that are not electrically connected to the underlying pillars or to any other elements of the semiconductor device. As is illustrated in Figures 1A, 1B and 2, a termination field plate electrode 44 may be arranged adjacent to the outer edge of the edge termination region 210. The termination field plate electrode 44 may be electrically connected to the furthest edge of the drift region 35. Such field plates are generally known and will, therefore, not be described in further detail herein.

Many applications require the switching of undamped inductive loads which may cause high stresses within the transistor device due to high currents which induce high device temperatures. In some applications, the avalanche capability of the transistor device is limited and stress exerted on the transistor device may result in local defects, especially in the peripheral regions of the active device cells near the edge termination. Such local defects may eventually lead to the failure of the device.

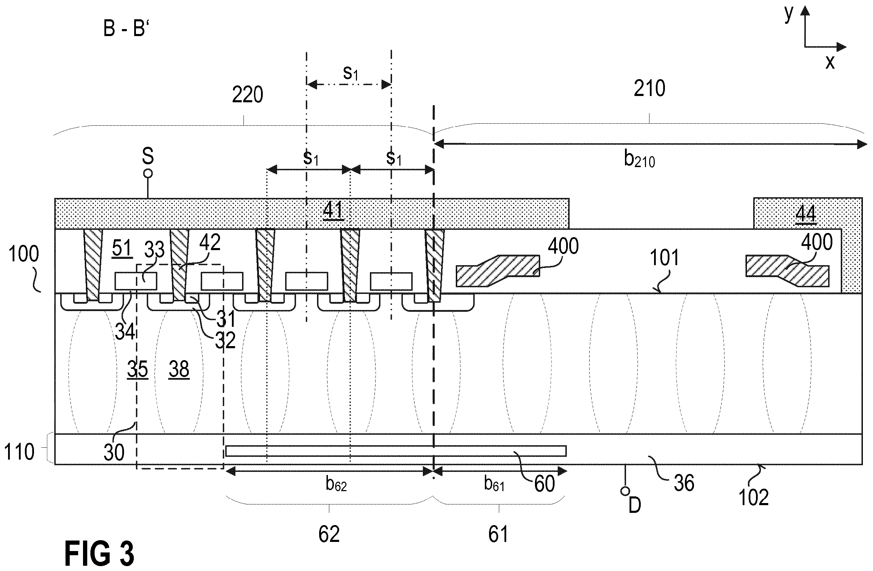

A more robust semiconductor device having an increased avalanche capability and an increased lifetime as compared to the semiconductor devices of Figures 1 and 2 is schematically illustrated in Figure 3. The device of Figure 3 is a device according to an example of the invention. The semiconductor device of Figure 3 generally corresponds to the semiconductor device of Figure 1B. However, the semiconductor device of Figure 3 additionally comprises a buffer region 60 that is arranged in the first semiconductor layer 110. That is, the buffer region 60 is arranged between the second surface 102 and the drift region 35, more specifically, between the second surface 102 and the pillars formed by the drift region 35 and the compensation regions 38. In the example of Figure 3, the buffer region 60 comprises a first section 61 and an adjoining second section 62. The first section 61 extends into the edge termination region 210, and the second section 62 extends into the active region 220. The first section 61 has a first width b₆₁ in the horizontal direction x, and the second section 62 has a second width b₆₂ in the horizontal direction x. According to the invention, the second section 62 has a second width b₆₂ that is at least twice the width of a first pitch. The first pitch is defined by a distance between a central axis (or central plane) of a first compensation region 38 and a central axis (or central plane) of a successive compensation region 38, with no other compensation regions 38 being arranged between the two successive compensation regions 38. The central axis (or central plane) of a compensation region 38 extends in the vertical direction y and divides the compensation region 38 in two essentially equal halves. This is schematically illustrated in Figure 3.

However, according to an example not covered by the claims, the transistor device does not necessarily comprise compensation regions 38. In a semiconductor device not comprising any compensation regions, the second section 62 may have a second width b₆₂ which is at least twice the width si of a transistor cell 30. The width si of a transistor cell 30 may be defined by a distance between the centers of two neighboring gate electrodes 33, as is schematically illustrated in dotdashed lines in the Figures. The width of a transistor cell 30 may equal the width of the first pitch. Within the same semiconductor device, each first pitch and/or each transistor cell 30 generally has an identical width si as compared to the other first pitches/transistor cells 30 in the transistor device. A minimum second width b₆₂ of at least twice the width si of a first pitch or a transistor cell 30 may be necessary to obtain a noticeable increase of the avalanche capability of the semiconductor device. The cffcct may further increase with an increasing width b₆₂ of the second section 62. However, when a certain width b₆₂ of the second section 62 is reached, the second section 62 may adversely affect the on-resistance Rₒₙ of the semiconductor device. Therefore, the second width b₆₂ may be less than a predefined maximum width, e.g., less than a width of the active region 220. According to the invention, the second width b62 is less than twenty times the width si of a first pitch or a transistor cell 30 or even less than ten times the width si of a first pitch or a transistor cell 30. According to one example, the second width b₆₂ is between four and eight times the width si of a first pitch or a transistor cell 30. The width si of a first pitch or a transistor cell 30 may be between 3µm and 10µm, for example. According to one example, the width si of a first pitch or a transistor cell 30 is about 5.5µm. Any other suitable widths si, however, are also possible.

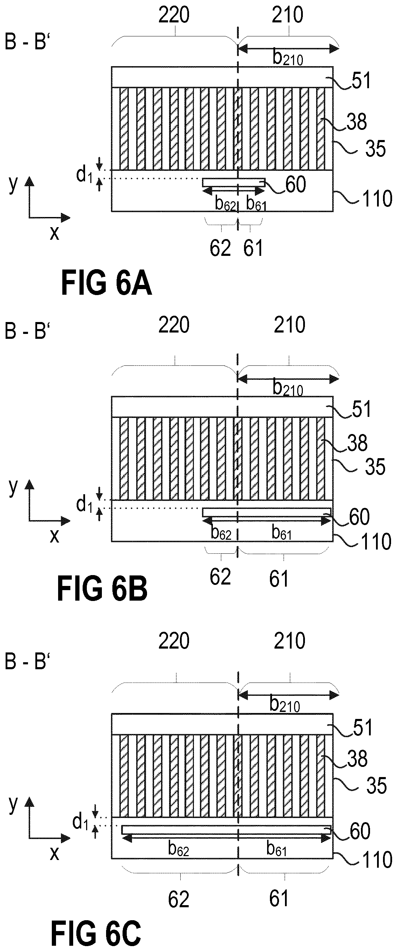

The first width b₆₁ of the first section 61 may equal a width b₂₁₀ of the edge termination region 210 or may be less than the width b₂₁₀ of the edge termination region 210. Generally it may be sufficient if the first section 61 extends into the edge termination region 210 only marginally. Examples of different dimensions of the first section 61 and the second section 62 are schematically illustrated in Figure 6. Referring to Figure 6A, for example, the first section 61 may have a minimal width b₆₁ in the horizontal direction x and the second section 62 may have a minimal width b₆₂ₘᵢₙ of twice the width si of a first pitch or a transistor cell 30. The minimal width b₆₁ of the first section 61 may be as small as the width si of a single first pitch or a single transistor cell 30, or even less. In the example that is illustrated in Figure 6B, the second section 62 has a minimal width b₆₂ of twice the width si of a first pitch or a transistor cell 30 and the first section 61 has a width b₆₁ which essentially equals the width b₂₁₀ of the edge termination region 210. In the example of Figure 6C, the first section 61 has a width b₆₁ which essentially equals the width b₂₁₀ of the edge termination region 210, and the second section 62 has a width b₆₂ which is greater than the minimal width b₆₂ₘᵢₙ of twice the width si of a first pitch or a transistor cell 30. The dimensions illustrated in Figures 6A - 6C, however, are only examples. Any other widths b₆₁, b₆₂ of the first and second sections 61, 62 are possible, such that 0 < b₆₁ < b₂₁₀, and b₆₂ₘᵢₙ < b₆₂ < b₆₂ₘₐₓ, with b₆₂ₘᵢₙ = 2^{∗}s₁ and b62max = 10^{∗}s₁, for example. Figures 6A - 6C illustrate the semiconductor device only very roughly. The transistor device, for example, as well as other elements, are not specifically illustrated in Figure 6 for convenience only.

Defects such as, e.g., burn marks caused by high currents and/or temperatures, often occur in the active region 220, close to the border between the active region 220 and the edge termination region 210. Due to avalanche effects, the temperature and the current in this part of the active region 220 may increase until the thermally generated carrier concentration is too high for the semiconductor device to support the applied voltage. In particular, the localization of the impact ionization for the active transistor cells 30 may occur near the edge of the active region 220 under high current conditions. The local concentration of the current may lead to the filamentation and, as a consequence, to a destruction of the device. Arranging the buffer region 60 in this critical (edge) region of the active region 220 increases the avalanche capability of those parts of the active region 220 that are close to the edge termination region 210 and, therefore, reduces the defects described above (e.g., burn marks). In particular, the buffer region 60 may prevent the peripheral transistor cells 30 from taking over most of the current during an avalanche condition. The buffer region 60 may modify a breakdown curve of peripheral transistor cells 30. However the modifications are not large at least for small currents, e.g., up to 0.1A/mm².

The buffer region 60 either has a doping type which is complementary to the doping type of the first semiconductor layer 110 (floating buffer region 60), or the buffer region 60 has the same doping type as the first semiconductor layer 110 but a doping concentration which is lower than a doping concentration of the first semiconductor layer 110 (non-floating buffer region 60). Generally, using small implantation doses for forming the buffer layer 60 may be sufficient to improve the avalanche capability of the semiconductor device. For example, implantation doses of about 0.5E12 cm⁻² may be used for forming the buffer region 60. Accordingly, a resulting doping concentration of the buffer region 60 may be selected from a range of about 1E15 cm⁻³ and 10E15 cm⁻³, for example.

Forming the buffer region 60 may comprise forming the first semiconductor layer 110 and subsequently implanting ions, e.g., boron, into the first semiconductor layer 110. It is, however, also possible to form the buffer region 60 during the growth process that is used to form the first semiconductor layer 110.

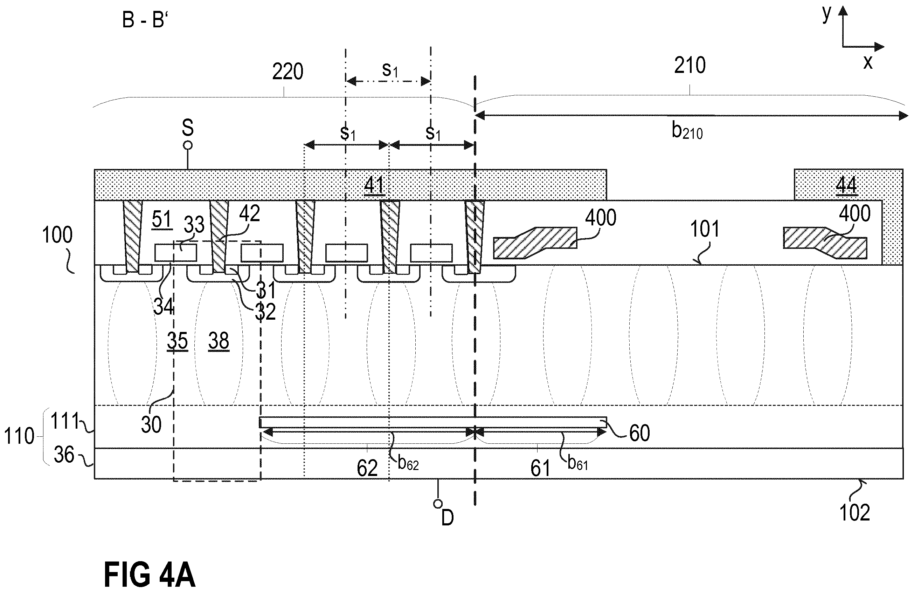

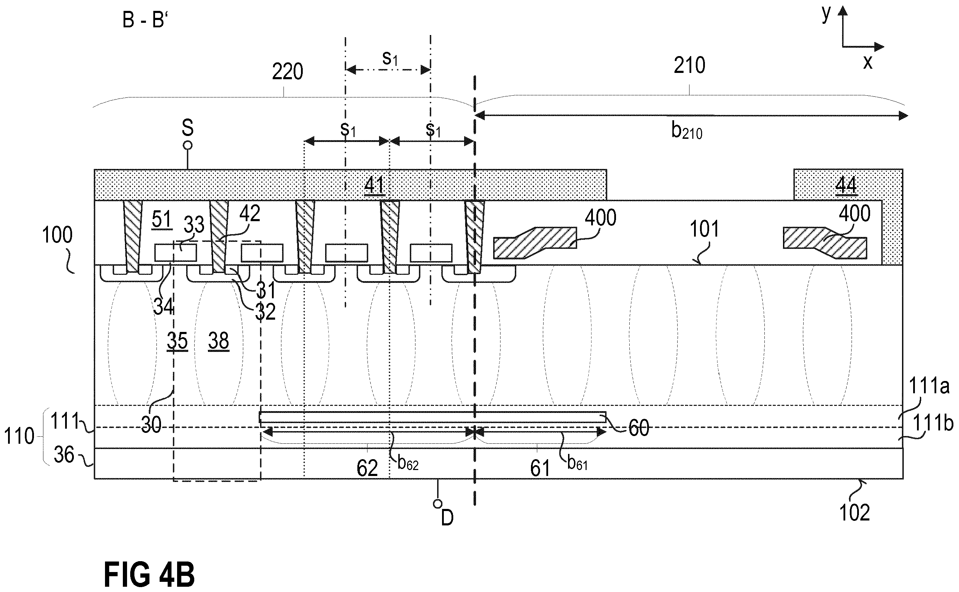

In the example that is illustrated in Figure 3, the first semiconductor layer 110 is formed by the drain region 36 of the semiconductor device. In this case, the buffer region 60 may be arranged within the drain region 36. However, as has been described with respect to Figure 2 above, the first semiconductor layer 110 may comprise the drain region 36 and a field-stop-region 111. In this case, the buffer region 60 may be arranged within the field-stop-region 111, for example, as is exemplarily illustrated in Figures 4A, 4B and 4C. In the example illustrated in Figure 4A, the field-stop-region 111 is formed by a single layer. In the examples illustrated in Figures 4B and 4C, the field-stop-region 111 comprises two sub-layers 111a, 111b. According to one example, the buffer region 60 may be arranged within the uppermost sub-layer 111a of a plurality of sub-layers. The uppermost sub-layer in this context is a sub-layer that is arranged closest (e.g., directly adjacent) to the drift regions 35. When arranged in one of the sub-layers, the buffer region 60 may be completely surrounded by the material forming the respective sub-layer, as is exemplarily illustrated in Figure 4B. This, however, is only an example. According to another example (see Figure 4C), the buffer region 60 may be only partly enclosed by the material forming the respective sub-layer 111a and may adjoin another one of the sub-layers 111b, e.g., with a lower surface. A lower surface of the buffer region 60 in this context is a surface facing towards the second surface 102 of the semiconductor body 100. According to an even further example (not illustrated), the buffer region 60 may extend over two or more sub-layers.

Referring to Figure 4C, a transistor device comprising a plurality of transistor cells 30 that are implemented as trench transistor cells is exemplarily illustrated. That is, the at least one gate electrode 33 is arranged in a trench that extends from the first surface 101 of the semiconductor body 100 into the semiconductor body 100. Similar to planar transistor cells, each transistor cell 30 includes a source region 31, a body region 32, a drift region 35, and a drain region 36, wherein the body region 32 separates the drift region 35 from the source region 31. Further, each transistor cell 30 includes a gate electrode 33, and the body region 32 is arranged adjacent to this gate electrode 33 and is dielectrically insulated from the gate electrode 33 by a gate dielectric 34. In a conventional fashion, the at least one gate electrode 33 serves to control a conducting channel in the body region 32 between the source region 31 and the drift region 35. The source region 31 and the body region 32 of each transistor cell 30 are electrically connected to the metallization 41 that forms a source node S of the transistor device or that is electrically connected to the source node S. The at least one gate electrode 33 is dielectrically insulated from the source metallization 41 by the insulation layer 51. The source metallization 41 is electrically connected to the source region 31 and the body region 32 via a contact plug. This contact plug is electrically (ohmically) connected to the source region 31 and the body region 32.

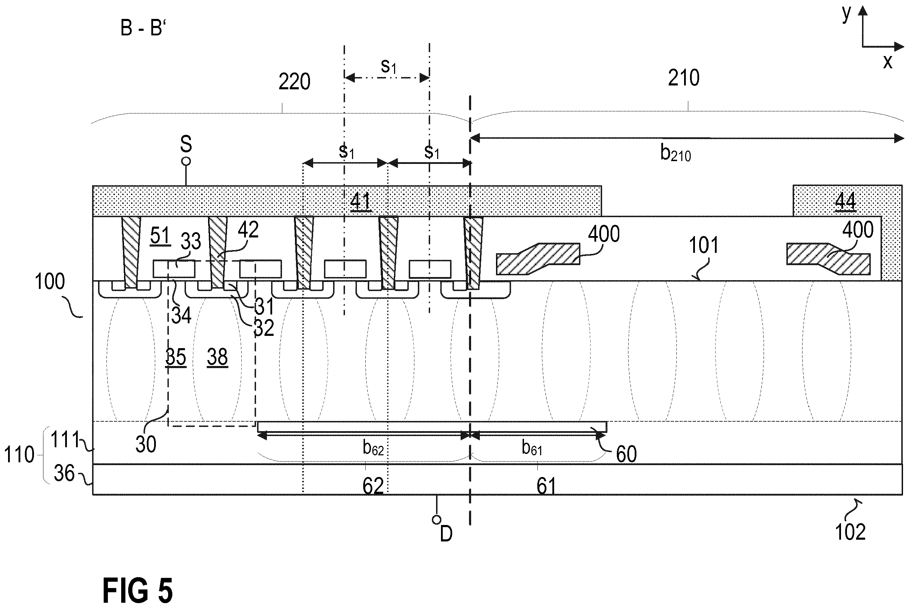

In Figures 3 and 4, for the purpose of illustration, the buffer region 60 is arranged distant to the drift regions 35 and the compensation regions 38 in a vertical direction y of the semiconductor body 100. The buffer region 60, e.g., may be a floating region having a net doping type that is complementary to the doping type of the field-stop-region 111. The buffer region 60 being a floating region in this context means that the buffer region 60 forms a pn-junction with the first semiconductor layer 110 in a vertical direction y towards the first surface 101. A distance di between the drift regions 35 and the buffer region 60 may be > 0 (see also Figure 6). For a floating buffer region 60, the distance di is defined by the distance between the pn-junction that is formed between the buffer region 60 and the first semiconductor layer 110 (e.g., the field-stop-region 111) in the vertical direction y towards the first surface 101, and a pn-junction that is formed between the compensation regions 38 and the first semiconductor layer 110. For example, the distance di between the two pn-junctions in the vertical direction y may be between 4µm and 10µm. The buffer region 60 being arranged distant to the drift regions 35 and the compensation regions 38 in a vertical direction y of the semiconductor body 100 (di > 0), however, is only an example. According to another example, as is exemplarily illustrated in Figure 5, the buffer region 60 may be arranged adjacent to the drift regions 35 and compensation regions 38 (di = 0). Arranging the buffer region 60 closer to the drift regions 35, however, may affect the small current characteristic of the semiconductor device to a certain degree which might not be desirable for all applications.

Further, the buffer region 60 being a floating region is only an example. According to another example, the buffer region 60 may be a non-floating region. The buffer region 60 being a non-floating region refers to a buffer region 60 having the same doping type as the first semiconductor layer 110. That is, a non-floating buffer region 60 does not form a pn-junction with the first semiconductor layer 110 (e.g., with the field-stop-region 111). The doping concentration of a buffer region 60 is generally not constant throughout the buffer region 60 in the vertical direction y. Usually, due to manufacturing processes, the doping concentration in a central part of the buffer region 60 is different from a doping concentration of the buffer region 60 at its vertical edges. That is, the doping concentration may decrease within the buffer region 60 from a central region towards the second surface 102 and towards the first surface 101. The distance di, in the context of a non-floating buffer region, refers to a distance between the pn-junction formed by the drift region 35 and the first semiconductor layer 110, and a region of the buffer region 60 in which a doping concentration is at least 10% lower than the doping concentration of the surrounding first semiconductor layer 110.

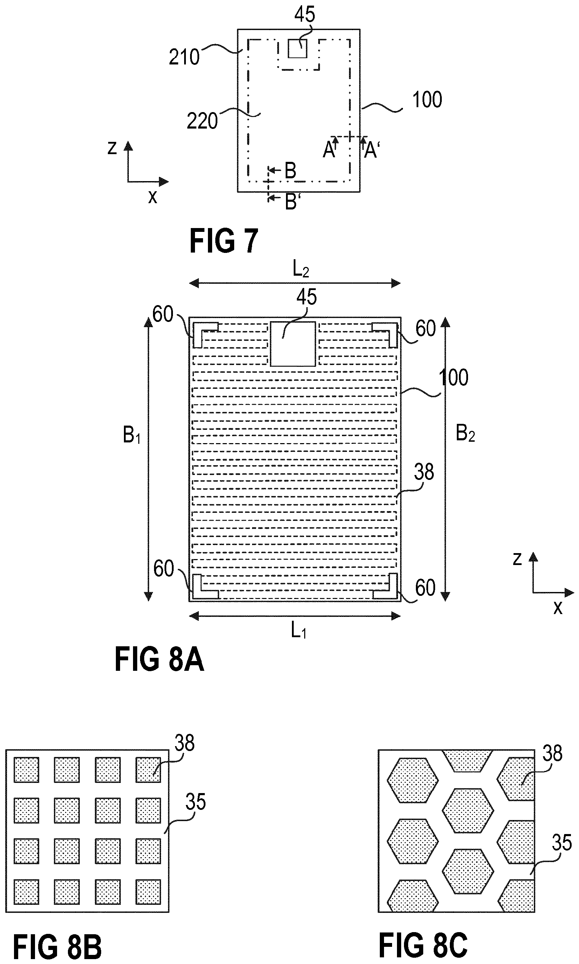

Now, referring to Figure 7, a top view of a semiconductor device is schematically illustrated. In particular, Figure 7 illustrates a top view of a semiconductor body 100 comprising an active region 220 and an edge termination region 210. The boundary between the edge termination region 210 and the active region 220 is indicated with a dotdashed line. As has been described before, the active region 220 may horizontally be surrounded by the edge termination region 210. For example, the semiconductor body 100 may have a rectangular shape. The edge termination region 210 may extend along all four edges of the semiconductor body 100. Figure 7 further illustrates a gate pad 45. The gate pad 45 may be electrically connected to the gate electrodes 33 of the transistor device. The gate pad 45 may be arranged in the edge termination region 210. As is illustrated in Figure 7, the edge termination region 210 may have an irregular pattern in order to provide an area for forming the gate pad 45. In Figure 7, the gate pad 45 is illustrated centered along one of the sides of the semiconductor body 100. This, however, is only an example. The gate pad 45, e.g., may also be arranged at one of the corners of the semiconductor body 100, or at any other suitable position. According to another example, the gate pad 45 may be arranged within the active region 220 of the semiconductor body 100. Figures 1 to 4, for example, illustrate cross-sectional views of the semiconductor device of Figure 7 in a section plane B - B'.

Now referring to Figure 8, different examples of the semiconductor body 100 of Figure 7 are illustrated in greater detail. The compensation regions 38 are indicated in dashed lines in Figure 8A. Each of the compensation regions 38 in Figure 8A is an elongated region. That is, a length of each compensation region 38 in a first horizontal direction x is considerably larger than a width of the compensation regions 38 in a second horizontal direction z that is perpendicular to the first horizontal direction x. This however, is only an example. As is illustrated in Figures 8B and 8C, for example, each of which illustrates only a small section of a semiconductor body 100, the compensation regions 38 are not necessarily elongated structures. For example, when seen from above, each of the compensation regions 38 may have an essentially rectangular cross-section (see, e.g., Figure 8B). However, any other polygonal cross-section is also possible (see, e.g., the hexagonal cross-section of Figure 8C). Even further, any round or irregular cross-sections are also possible. In the examples of Figures 8B and 8C, the compensation regions 38 are completely surrounded by the drift region 35 in a horizontal plane.

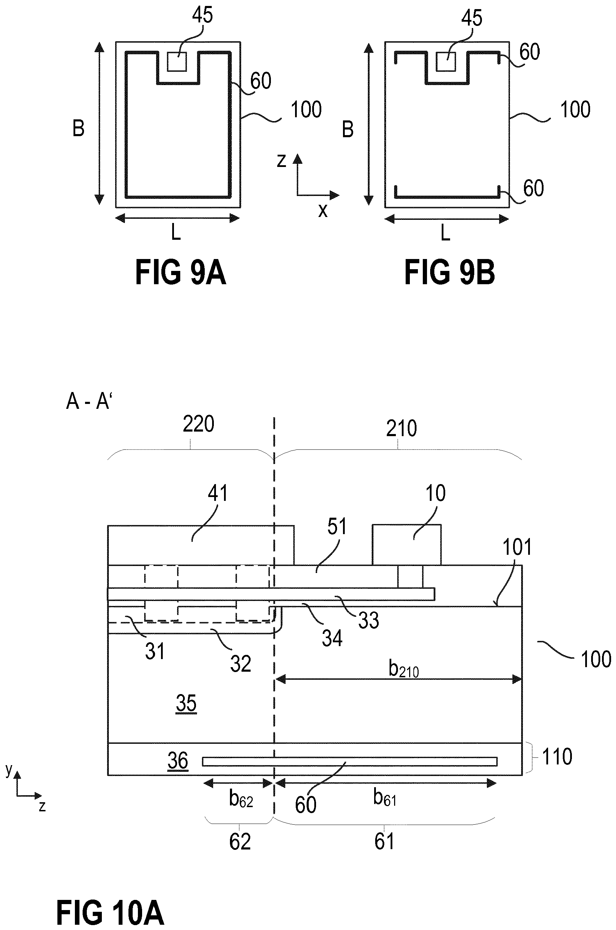

As is illustrated in Figure 8A, the buffer region 60 may comprise a plurality of different sections. For example, one section of the buffer region 60 may be arranged in each of the corners of the semiconductor body 100. This, however, is only an example. As is illustrated in Figure 9A, the buffer region 60 may alternatively be formed as a continuous region along the boundary between the active region 220 and the edge termination region 210. The semiconductor body 100 may comprise first and second longitudinal sides L₁, L₂, and first and second narrow sides B₁, B₂. Longitudinal and narrow in this context, however, do not refer to the dimensions of the semiconductor body 100 itself. Longitudinal and narrow rather refers to the dimensions of the compensation regions 38, as has been illustrated with regard to Figure 8A above. That is, a longitudinal side L₁, L₂ is a side of the semiconductor body 100 extending in the first horizontal direction x parallel to the longitudinal sides of the compensation regions 38, and a narrow side B₁, B₂ is a side of the semiconductor body 100 extending in the second horizontal direction z, parallel to the narrow sides of the compensation regions 38.

Now referring to Figure 9B, the buffer region 60 may comprise two sections which extend along the longitudinal sides L₁, L₂ of the semiconductor body 100, and which extend only partly along the narrow sides B₁, B₂ of the semiconductor body 100. According to another example (not illustrated), it is possible that the buffer region 60 comprises two sections which extend along the narrow sides B₁, B₂ of the semiconductor body 100, and only partly along the longitudinal sides L₁, L₂ of the semiconductor body 100. The buffer region 60 may comprise at least one section, and may at least one of extend at least partly along one or both of the narrow sides B₁, B₂ of the semiconductor body 100, and extend at least partly along one or both of the longitudinal sides L₁, L₂ of the semiconductor body 100.

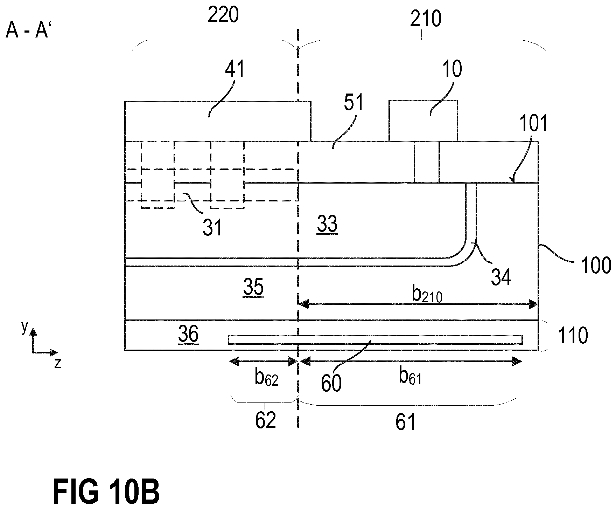

Now referring to Figures 10A and 10B, cross-sectional views of the semiconductor device of Figure 7 in a section plane A-A' are schematically illustrated. Figure 10A schematically illustrates a cross-sectional view of a planar transistor device, while Figure 10B schematically illustrates a cross-sectional view of a transistor device comprising transistor cells 30 that are implemented as trench transistor cells. Referring to Figures 10A and 10B, the gate electrodes 33 of the transistor cells 30 may be provided as a plurality of longitudinal semiconductor regions. A length of the gate electrodes 33 in the second horizontal direction z may be considerably larger than a respective width in the first horizontal direction x, the horizontal directions x, z being perpendicular to each other. The gate electrodes 33 may have an elongated form that is similar to the form of the compensation regions 38, as illustrated in Figure 8A. Each of the gate electrodes 33 may be electrically connected to a so-called gate runner 10, for example (not illustrated in Figures 1 to 9). The gate runner 10 may be a circumferential, electrically conducting layer which electrically couples the gate electrodes 33 to the gate pad 45. In the examples illustrated in Figures 10A and 10B, the gate runner 10 overlaps each of the longitudinal gate electrodes 33, that is, at least one end of each of the gate electrodes 33 is located below the gate runner 10 in the vertical direction y. According to one example, all ends of the gate electrodes 33 that are overlapped by the gate runner 10 are electrically connected to the gate runner 10. However, it is also possible that some ends that are overlapped by the gate runner 10 are not directly connected to the gate runner 10 (not illustrated in the Figures). "Not directly connected" means that there is no via between the longitudinal end of the respective gate electrodes 33 and the gate runner 10. However, such longitudinal ends may still be indirectly connected to the gate runner 10 via another one of the gate electrodes 33.

As has been described with respect to Figures 1 to 5 above, an insulation layer 51 is formed on top of the first surface 101 of the semiconductor body 100. As is illustrated in Figure 10, the gate runner 10 may be formed on this insulation layer 51. A source region 31 is illustrated in dashed lines in Figures 10A and 10B, as it is arranged in a plane different from the plane that is illustrated in the Figures and is not immediately visible in the cross-sections of Figures 10A and 10B. The same applies for the contact plugs 42 that are also illustrated in dashed lines. Along the longitudinal sides Li, L₂ of the semiconductor body 100, the boundary between the edge termination region 210 and the active region 220 is usually defined by the lateral end of the source region 31. That is, the width b₂₁₀ of the edge termination region 210 generally corresponds to a distance between the source region 31 and the edge of the semiconductor body 100. This, however, is only an example.

As is illustrated in the Figures, the compensation regions 38 may not only be arranged in the active region 220 of the semiconductor body 100. It is also possible that compensation regions 38 extend into or are arranged in the edge termination region 210. However, according to one example, those sections of the compensation regions that are arranged in the edge termination region 210 may have a different doping concentration than the sections of the compensation regions 38 that are arranged in the active region 220. The boundary between the active region 220 and the edge termination region 210 in such semiconductor devices may be defined by a boundary between sections of the compensation region 38 having a first doping concentration and sections of the compensation region 38 having a second doping concentration that is different from the first doping concentration.

In the Figures, the buffer region 60 has been illustrated as a continuous region, wherein a dimension of the first section 61 in the vertical direction y (thickness of the first section 61) equals a dimension of the second section 62 in the vertical direction y (thickness of the second section 62). This, however, is only an example. According to another example, a dimension of the first section 61 in the vertical direction y may be different from a dimension of the second section 62 in the vertical direction (thickness of first section 61 < thickness of second section 62, or thickness of first section 61 > thickness of second section 62). According to a further example, the first section 61 and the second section 62 may not be connected to each other. That is, a recess may be formed between the first section 61 and the second section 62. The width of such a recess in the horizontal direction x, however, may be less than the width si of a first pitch or a transistor cell 30. A recess in this context may be a region that has the first doping type and may be regarded as part of the first semiconductor layer 110.

According to another example, the doping concentration of the buffer region 60 may vary along its width in the horizontal direction. In particular, at least one of the doping concentration of the first section 61 may vary along its width b₆₁, and the doping concentration of the second section 62 may vary along its width b₆₂. That is, each of the first section 61 and the second section 62 may comprise more highly doped regions and less highly doped regions. A less highly doped region may be arranged between two more highly doped regions in the horizontal direction. The first section 61 and the second section 62 may each be continuous sections. However, it is also possible that at least one of the first section 61 and the second section 62 comprise at least one recess. A recess in this context may also be a region that has the first doping type and may be regarded as part of the first semiconductor layer 110. Similar to an optional recess between the first section 61 and the second section 62, the width of such a recess in the horizontal direction may be less than the width si of a first pitch or a transistor cell 30. If the width of a recess becomes too large, the effect of the buffer layer 60 could be diminished.

For many applications, however, it may be desirable to form a continuous buffer region 60 without any recesses between the first section 61 and the second section 62 or within the first and the second section 61, 62. However, small recesses may be tolerable for some applications.

## Claims

1. A vertical semiconductor device, comprising:
a semiconductor body (100) comprising a first surface (101), a second surface (102) opposite to the first surface (101) in a vertical direction, an edge termination region (210), and an active region (220) arranged adjacent to the edge termination region (210) in a horizontal direction;
a plurality of transistor cells (30) at least partly integrated in the active region (220), each transistor cell (30) comprising a source region (31), a body region (32), a drift region (35) separated from the source region (31) by the body region (32), and a gate electrode (33) dielectrically insulated from the body region (32) ;
a first semiconductor layer (110) of a first doping type arranged between the drift regions (35) and the second surface (102) in the edge termination region (210) and in the active region (220); and
a buffer region (60) arranged in the first semiconductor layer (110) and comprising a first section (61) extending in the horizontal direction into the edge termination region (210), and a second section (62) extending in the horizontal direction into the active region (220),
wherein the second section (62) has a width (b₆₂) in the horizontal direction which is at least twice the width (s₁) and less than twenty times the width (s₁) of a first pitch,
wherein the buffer region (60) either has a second doping type complementary to the first doping type, or has the first doping type and a doping concentration lower than a doping concentration of the first semiconductor layer (110),
wherein each of the plurality of transistor cells (30) further comprises a compensation region (38) of a doping type complementary to the doping type of the drift region (35) and extending from a respective body region (32) into the drift region (35) in the vertical direction, and
wherein the width (s₁) of a first pitch equals a distance between the central planes of two successive compensation regions (38).

2. The vertical semiconductor device of claim 1, wherein the width (b₆₂) of the second section (62) is less than ten times the width (s₁) of the first pitch.

3. The vertical semiconductor device of claim 1 or 2, wherein
the buffer region (60) has the second doping type; and
the buffer region (60) is surrounded by the material of the first semiconductor layer (110) and forms a pn-junction with the first semiconductor layer (110) in a vertical direction (y) towards the first surface (101).

4. The vertical semiconductor device of claim 3, wherein a distance (d₁) between the drift region (35) and the pn-junction that is formed between the buffer region (60) and the first semiconductor layer (110) in the vertical direction (y) is between 4µm and 10µm.

5. The vertical semiconductor device of claim 4, wherein the distance (d₁) between the drift region (35) and the pn-junction that is formed between the buffer region (60) and the first semiconductor layer (110) in the vertical direction is between 4µm and 5µm

6. The vertical semiconductor device of claim 1 or 2, wherein
the buffer region (60) has the first doping type; and
wherein a distance (d₁) between the drift region (35) and a region of the buffer region (60) having a net doping concentration that is at least 10% lower than the doping concentration of the first semiconductor layer (110) in the vertical direction (y) is between 4µm and 10µm.

7. The vertical semiconductor device of any of claims 1 to 6, wherein
the semiconductor body (100) comprises first and second longitudinal sides (L₁, L₂) and first and second narrow sides (B₁, B₂);
the edge termination region (210) is a circumferential region surrounding the active region (220); and wherein at least one of:
the buffer region (60) extends at least partly along one or both of the narrow sides (B₁, B₂) of the semiconductor body (100), and
the buffer region (60) extends at least partly along one or both of the longitudinal sides (L₁, L₂) of the semiconductor body (100).

8. The vertical semiconductor device of any of the preceding claims, wherein the first semiconductor layer (110) is a drain region (36).

9. The vertical semiconductor device of any of claims 1 to 7, wherein
the first semiconductor layer (110) comprises a drain region (36) of the first doping type adjacent to the second surface (102), and a field-stop-region (111) of the first doping type arranged between the drain region (36) and the drift region (35); and
the drain region (36) has a doping concentration that is higher than a doping concentration of the field-stop-region (111).

10. The vertical semiconductor device of claim 9, wherein the buffer region (60) is arranged in the field-stop-region (111).

11. The vertical semiconductor device of any of the preceding claims, wherein the first section (61) of the buffer region (60) has a width (b₆₁) in the horizontal direction which is less than a width (b₂₁₀) of the edge termination region (210) in the horizontal direction.

12. The vertical semiconductor device of any of the preceding claims, wherein at least one of:
the doping concentration of the first section (61) varies along its width (b₆₁) in the horizontal direction;
the doping concentration of the second section (62) varies along its width (b₆₂) in the horizontal direction; and
a dimension of the first section (61) in the vertical direction (y) differs from a dimension of the second section (62) in the vertical direction (y).

13. The vertical semiconductor device of any of the preceding claims, wherein at least one of:
the buffer region (60) comprises a recess between the first section (61) and the second section (62), wherein the recess has a width that is less than once the width (s₁) of the first pitch;
the first section (61) comprises at least one recess, wherein each recess has a width that is less than once the width (s₁) of the first pitch; and
the second section (62) comprises at least one recess, wherein each recess has a width that is less than once the width (s₁) of the first pitch.

## Patentansprüche

1. Vertikalhalbleiterbauelement, umfassend:
einen Halbleiterkörper (100), umfassend eine erste Oberfläche (101), eine zweite Oberfläche (102) gegenüber der ersten Oberfläche (101) in einer vertikalen Richtung, ein Randabschlussgebiet (210) und ein Aktivgebiet (220), angeordnet bei dem Randabschlussgebiet (210) in einer horizontalen Richtung;
mehrere Transistorzellen (30), die mindestens teilweise in das Aktivgebiet (220) integriert sind, wobei jede Transistorzelle (30) ein Sourcegebiet (31), ein Körpergebiet (32), ein durch das Körpergebiet (32) von dem Sourcegebiet (31) getrenntes Driftgebiet (35) und eine dielektrisch von dem Körpergebiet (32) isolierte Gateelektrode (33) umfasst;
eine erste Halbleiterschicht (110) eines ersten Dotierungstyps, angeordnet zwischen den Driftgebieten (35) und der zweiten Oberfläche (102) in dem Randabschlussgebiet (210) und in dem Aktivgebiet (220); und
ein Puffergebiet (60), angeordnet in der ersten Halbleiterschicht (110) und umfassend eine sich in der horizontalen Richtung in das Randabschlussgebiet (210) erstreckende erste Sektion (61), und eine sich in der horizontalen Richtung in das Aktivgebiet (220) erstreckende zweite Sektion (62),
wobei die zweite Sektion (62) eine Breite (b₆₂) in der horizontalen Richtung aufweist, die mindestens das Doppelte der Breite (s₁) und weniger als das Zwanzigfache der Breite (s₁) einer ersten Teilung beträgt,
wobei das Puffergebiet (60) entweder einen zweiten Dotierungstyp komplementär zu dem ersten Dotierungstyp aufweist oder den ersten Dotierungstyp und eine Dotierungskonzentration unter einer Dotierungskonzentration der ersten Halbleiterschicht (110) aufweist,
wobei jede der mehreren Transistorzellen (30) weiter ein Kompensationsgebiet (38) eines Dotierungstyps komplementär zu dem Dotierungstyp des Driftgebiets (35) und sich von einem jeweiligen Körpergebiet (32) in das Driftgebiet (35) in der vertikalen Richtung erstreckend umfasst, und
wobei die Breite (s₁) einer ersten Teilung gleich einer Distanz zwischen den mittleren Ebenen von zwei aufeinanderfolgenden Kompensationsgebieten (38) ist.

2. Vertikalhalbleiterbauelement nach Anspruch 1, wobei die Breite (b₆₂) der zweiten Sektion (62) weniger als das Zehnfache der Breite (s₁) der ersten Teilung beträgt.

3. Vertikalhalbleiterbauelement nach Anspruch 1 oder 2, wobei
das Puffergebiet (60) den zweiten Dotierungstyp aufweist; und
das Puffergebiet (60) durch das Material der ersten Halbleiterschicht (110) umgeben ist und einen pn-Übergang mit der ersten Halbleiterschicht (110) in einer vertikalen Richtung (y) zu der ersten Oberfläche (101) bildet.

4. Vertikalhalbleiterbauelement nach Anspruch 3, wobei eine Distanz (d₁) zwischen dem Driftgebiet (35) und dem pn-Übergang, der zwischen dem Puffergebiet (60) und der ersten Halbleiterschicht (110) in der vertikalen Richtung (y) gebildet ist, zwischen 4 µm und 10 µm beträgt.

5. Vertikalhalbleiterbauelement nach Anspruch 4, wobei die Distanz (d₁) zwischen dem Driftgebiet (35) und dem pn-Übergang, der zwischen dem Puffergebiet (60) und der ersten Halbleiterschicht (110) in der vertikalen Richtung gebildet ist, zwischen 4 µm und 5 µm beträgt.

6. Vertikalhalbleiterbauelement nach Anspruch 1 oder 2, wobei
das Puffergebiet (60) den ersten Dotierungstyp aufweist; und
wobei eine Distanz (d₁) zwischen dem Driftgebiet (35) und einem Gebiet des Puffergebiets (60) mit einer Nettodotierungskonzentration, die mindestens 10% unter der Dotierungskonzentration der ersten Halbleiterschicht (110) in der vertikalen Richtung (y) liegt, zwischen 4 µm und 10 µm beträgt.

7. Vertikalhalbleiterbauelement nach einem der Ansprüche 1 bis 6, wobei
der Halbleiterkörper (100) eine erste und zweite longitudinale Seite (L₁, L₂) und eine erste und zweite schmale Seite (B₁, B₂) aufweist;
das Randabschlussgebiet (210) ein Umfangsgebiet ist, das das Aktivgebiet (220) umgibt; und wobei mindestens eines der folgenden zutrifft:
das Puffergebiet (60) erstreckt sich mindestens teilweise entlang einer oder beiden der schmalen Seiten (B₁, B₂) des Halbleiterkörpers (100), und
das Puffergebiet (60) erstreckt sich mindestens teilweise entlang einer oder beiden der longitudinalen Seiten (L₁, L₂) des Halbleiterkörper (100).

8. Vertikalhalbleiterbauelement nach einem der vorhergehenden Ansprüche, wobei die erste Halbleiterschicht (110) ein Draingebiet (36) ist.

9. Vertikalhalbleiterbauelement nach einem der Ansprüche 1 bis 7, wobei
die erste Halbleiterschicht (110) ein Draingebiet (36) vom ersten Dotierungstyp bei der zweiten Oberfläche (102) und ein Feldstoppgebiet (111) vom ersten Dotierungstyp, angeordnet zwischen dem Draingebiet (36) und dem Driftgebiet (35), umfasst; und
das Draingebiet (36) eine Dotierungskonzentration aufweist, die höher ist als eine Dotierungskonzentration des Feldstoppgebiets (111).

10. Vertikalhalbleiterbauelement nach Anspruch 9, wobei das Puffergebiet (60) in dem Feldstoppgebiet (111) angeordnet ist.

11. Vertikalhalbleiterbauelement nach einem der vorhergehenden Ansprüche, wobei die erste Sektion (61) des Puffergebiets (60) eine Breite (b₆₁) in der horizontalen Richtung aufweist, die kleiner ist als eine Breite (b₂₁₀) des Randabschlussgebiets (210) in der horizontalen Richtung.

12. Vertikalhalbleiterbauelement nach einem der vorhergehenden Ansprüche, wobei mindestens eines der folgenden zutrifft:
die Dotierungskonzentration der ersten Sektion (61) variiert entlang ihrer Breite (b₆₁) in der horizontalen Richtung;
die Dotierungskonzentration der zweiten Sektion (62) variiert entlang ihrer Breite (b₆₂) in der horizontalen Richtung; und
eine Abmessung der ersten Sektion (61) in der vertikalen Richtung (y) differiert von einer Abmessung der zweiten Sektion (62) in der vertikalen Richtung (y).

13. Vertikalhalbleiterbauelement nach einem der vorhergehenden Ansprüche, wobei mindestens eines der folgenden zutrifft:
die Pufferregion (60) umfasst eine Ausnehmung zwischen der ersten Sektion (61) und der zweiten Sektion (62), wobei die Ausnehmung eine Breite aufweist, die kleiner ist als das Einfache der Breite (s₁) der ersten Teilung;
die erste Sektion (61) umfasst mindestens eine Ausnehmung, wobei jede Ausnehmung eine Breite aufweist, die weniger ist als das Einmalige der Breite (s₁) der ersten Teilung; und
die zweite Sektion (62) umfasst mindestens eine Ausnehmung, wobei jede Ausnehmung eine Breite aufweist, die kleiner ist als das Einmalige der Breite (s₁) der ersten Teilung.

## Revendications

1. Dispositif à semiconducteur vertical, comprenant :
un corps (100) à semiconducteur comprenant une première surface (101), une deuxième surface (102) opposée à la première surface (101) dans une direction verticale, une région (210) de terminaison de bord et une région (220) active disposée au voisinage de la région (210) de terminaison de bord dans une direction horizontale ;
une pluralité de cellules (30) de transistor intégrées au moins en partie dans la région (220) active, chaque cellule (30) de transistor comprenant une région (31) de source, une région (32) de corps, une région (35) de migration séparée de la région (31) de source par la région (32) de corps et une électrode (33) de grille isolée diélectriquement de la région (32) de corps ;
une première couche (110) semiconductrice d'un premier type de dopage montée entre les régions (35) de migration et la deuxième surface (102) dans la région (210) de terminaison de bord et dans la région (220) active ; et
une région (60) de tampon disposée dans la première couche (110) semiconductrice et comprenant une première partie (61), s'étendant dans la direction horizontale dans la région (210) de terminaison de bord, et une deuxième partie (62), s'étendant dans la direction horizontale dans la région (220) active,
dans lequel la deuxième partie (62) a une largeur (b₆₂) dans la direction horizontale, qui représente au moins deux fois la largeur (s₁) et moins que vingt fois la largeur (s₁) d'un premier pas,
dans lequel la région (60) de tampon, ou bien a un deuxième type de dopage complémentaire du premier type de dopage, ou bien a le premier type de dopage et une concentration de dopage plus petite qu'une concentration de dopage de la première couche (110) semiconductrice,
dans lequel chacune de la pluralité de cellules (30) de transistor comprend en outre une région (38) de compensation d'un type de dopage complémentaire du type de dopage de la région (35) de migration et s'étendant à partir d'une région (32) de corps respective dans la région (35) de migration dans la direction verticale, et
dans lequel la largeur (s₁) d'un premier pas est égale à une distance entre les plans centraux de deux régions (38) successives de compensation.

2. Dispositif à semiconducteur vertical suivant la revendication 1, dans lequel la largeur (b₆₂) de la deuxième partie (62) est plus petite que dix fois la largeur (s₁) du premier pas.

3. Dispositif à semiconducteur vertical suivant la revendication 1 ou 2, dans lequel
la région (60) de tampon a le deuxième type de dopage ; et
la région (60) de tampon est entourée du matériau de la première couche (110) semiconductrice et forme une jonction pn avec la première couche (110) semiconductrice dans une direction (y) verticale allant vers la première surface (101).

4. Dispositif à semiconducteur vertical suivant la revendication 3, dans lequel une distance (d₁) entre la région (35) de migration et la jonction pn, qui est formée entre la région (60) de tampon et la première couche (110) semiconductrice dans la direction (y) verticale, est comprise entre 4 µm et 10 µm.

5. Dispositif à semiconducteur vertical suivant la revendication 4, dans lequel la distance (d₁) entre la région (35) de migration et la jonction pn, qui est formée entre la région (60) de tampon et la première couche (110) semiconductrice dans la direction verticale, est comprise entre 4 µm et 5 µm.

6. Dispositif à semiconducteur vertical suivant la revendication 1 ou 2, dans lequel
la région (60) de tampon a le première type de dopage ; et
dans lequel une distance (d₁) entre la région (35) de migration et une région de la région (60) tampon ayant une concentration de dopage nette, qui est inférieure d'au moins 10% à la concentration de dopage de la première couche (110) semiconductrice dans la direction (y) verticale, est comprise entre 4 µm et 10 µm.

7. Dispositif à semiconducteur vertical suivant l'une quelconque des revendications 1 à 6, dans lequel
le corps (100) à semiconducteur comprend des premiers et deuxièmes côtés (L₁, L₂) longitudinaux et des premiers et deuxièmes côtés (B₁, B₂) étroits ;
la région (210) de terminaison de bord est une région circonférentielle entourant la région (220) ; dans lequel au moins l'un de :
la région (60) de tampon s'étend au moins en partie le long de l'un ou des deux côtés (B₁, B₂) étroits du corps (100) à semiconducteur, et
la région (60) de tampon s'étend au moins en partie le long de l'un ou des deux des côtés (L₁, L₂) longitudinaux du corps (100) à semiconducteur.

8. Dispositif à semiconducteur vertical suivant l'une quelconque des revendications précédentes, dans lequel la première couche (110) semiconductrice est une région (36) de drain.

9. Dispositif à semiconducteur vertical suivant l'une quelconque des revendications 1 à 7, dans lequel
la première couche (110) semiconductrice comprend une région (36) de drain du premier type de dopage voisine de la deuxième surface (102), et une région (111) d'arrêt de champ du premier type de dopage disposée entre la région (36) de drain et la région (35) de migration ; et
la région (36) de drain a une concentration de dopage, qui est plus grande qu'une concentration de dopage, qui est plus grande qu'une concentration de dopage de la région (111) d'arrêt de champ.

10. Dispositif à semiconducteur vertical suivant la revendication 9, dans lequel la région (60) de tampon est disposée dans la région (111) d'arrêt de champ.

11. Dispositif à semiconducteur vertical suivant l'une quelconque des revendications précédentes, dans lequel la première partie (61) de la région (60) de tampon a une largeur (b₆₁) dans la direction horizontale, qui est plus petite qu'une largeur (b₂₁₀) de la région (210) de terminaison de bord dans la direction horizontale.

12. Dispositif à semiconducteur vertical suivant l'une quelconque des revendications précédentes, dans lequel au moins l'un de
la concentration de dopage de la première partie (61) varie suivant sa largeur (b₆₁) dans la direction horizontale ;
la concentration de dopage de la deuxième partie (62) varie suivant sa largeur (b₆₂) dans la direction horizontale ; et
une dimension de la première partie (61) dans la direction (y) verticale diffère d'une dimension de la deuxième partie (62) dans la direction (y) verticale.

13. Dispositif à semiconducteur vertical suivant l'une quelconque des revendications précédentes, dans lequel au moins l'un de :
la région (60) de tampon comprend un retrait entre la première partie (61) et la deuxième partie (62), dans lequel le retrait a une largeur, qui est plus petite qu'une fois la largeur (s₁) du premier pas ;
la première partie (61) comprend au moins un retrait, dans lequel chaque retrait a une largeur, qui est plus petite qu'une fois la largeur (s₁) du premier pas ; et
la deuxième partie (62) comprend au moins un retrait, dans lequel chaque retrait a une largeur, qui est plus petite qu'une fois la largeur (s₁) du premier pas.
